# EUROPEAN PATENT APPLICATION

(11) **EP 4 718 501 A1**
(43) Date of publication of application: **01.04.2026**
(21) Application number: 24835063.9
(22) Date of filing: 29.02.2024
(51) Int. Cl.: H01L 23/367

(54) **PACKAGE, CHIP, AND ELECTRONIC DEVICE**

(30) Priority: 06.07.2023 CN 202310827009
(71) Applicant: Huawei Technologies Co., Ltd., Shenzhen, Guangdong 518129 (CN)
(72) Inventor: CHEN, Yu, Shenzhen, Guangdong 518129 (CN); LI, Jiming, Shenzhen, Guangdong 518129 (CN); ZHAO, Yuchun, Shenzhen, Guangdong 518129 (CN); YANG, Chuncheng, Shenzhen, Guangdong 518129 (CN)
(74) Representative: Epping - Hermann - Fischer
(86) International application number: PCT/CN2024/079259
(87) International publication number: WO 2025/007576

(57) **Abstract**

Embodiments of this application provide a package, a chip, and an electronic apparatus. The package includes a substrate, and a first die, a second die, a first structural member, and a second structural member that are disposed on the substrate. A first dielectric material is disposed between the first die and the second die. The first structural member is disposed on a side that is of the first die and that is away from the substrate, and the first die is located in a region of orthographic projection of the first structural member on a surface of the substrate. The second structural member is disposed on a side that is of the second die and that is away from the substrate, the second die is located in a region of orthographic projection of the second structural member on the surface of the substrate, and there is an air gap between the first structural member and the second structural member. The first structural member and the second structural member in the package may respectively assist the first die and the second die in heat dissipation. Because the first die and the second die are neither directly connected nor in direct contact, and the first structural member and the second structural member are neither directly connected nor in direct contact, impact of thermal crosstalk between the dies can be reduced, and heat dissipation effect can be improved.

## Description

This application claims priority to Chinese Patent Application No. 202310827009.9, filed with the China National Intellectual Property Administration on July 6, 2023 and entitled "PACKAGE, CHIP, AND ELECTRONIC APPARATUS", which is incorporated herein by reference in its entirety.

### TECHNICAL FIELD

Embodiments of this application relate to the chip field, and more specifically, to a package, a chip, and an electronic apparatus.

### BACKGROUND

Currently, a plurality of dies (die) may be integrated in one chip, for example, a multi-chip module (multi-chip module, MCM) or a 2.5-dimensional (2.5 dimension, 2.5D) package form including an interposer (interposer). Because each die is a heat source, thermal crosstalk (thermal-crosstalk) may be generated between a plurality of dies. If a component is in a 3-dimensional (3 dimension, 3D) package form, a thermal problem of the 3D component further deteriorates due to thermal crosstalk, which adversely affects the 3D component. To facilitate thermal management of the chip, a current solution in the conventional technology is disposing a heat dissipation structure above the plurality of dies in the chip, so that the plurality of dies share a same heat dissipation resource. However, when power consumption and/or junction temperature specifications of different dies differ greatly, allocating the heat dissipation resource based on a die with high power consumption or a die with a low junction temperature specification is likely to lead to wastage of the heat dissipation resource. Another solution in the conventional technology is removing a metal protection lid (lid) and a thermal interface material (thermal interface material, TIM) above the plurality of dies in the chip, to reduce package thermal resistance. However, in the solution, the chip still needs to be in contact with a heat sink outside the chip via the TIM. Consequently, thermal crosstalk still exists between the plurality of dies inside the chip, and heat dissipation effect is not optimal.

Therefore, how to reduce impact of thermal crosstalk between the plurality of dies in the chip to improve heat dissipation effect becomes an urgent problem to be resolved.

### SUMMARY

Embodiments of this application provide a package, a chip, and an electronic apparatus. The package can reduce impact of thermal crosstalk between a plurality of dies in the package by using a plurality of structural members, to improve heat dissipation effect.

According to a first aspect, a package is provided. The package includes a substrate, and a first die, a second die, a first structural member, and a second structural member that are disposed on the substrate. A first dielectric material is disposed between the first die and the second die. The first structural member is disposed on a side that is of the first die and that is away from the substrate, and the first die is located in a region of orthographic projection of the first structural member on a surface of the substrate. The second structural member is disposed on a side that is of the second die and that is away from the substrate, the second die is located in a region of orthographic projection of the second structural member on the surface of the substrate, and there is an air gap between the first structural member and the second structural member.

In embodiments of this application, in the package, the first structural member may assist the first die in heat dissipation, and the second structural member may assist the second die in heat dissipation. Because the first die and the second die are neither directly connected nor in direct contact, and the first structural member and the second structural member are neither directly connected nor in direct contact, thermal insulation between the first die and the second die can be implemented, to reduce impact of thermal crosstalk between the first die and the second die, and further improve heat dissipation effect.

With reference to the first aspect, in some implementations of the first aspect, an edge of the first structural member includes a first bending part bent toward the substrate, and the first bending part is connected to the substrate; and/or an edge of the second structural member includes a second bending part bent toward the substrate, and the second bending part is connected to the substrate.

In embodiments of this application, the first structural member may be connected to the substrate via the first bending part at the edge, to fasten the first structural member to the substrate, and prevent the first structural member from moving on or falling off the surface of the substrate. Similarly, the second structural member may be connected to the substrate via the second bending part at the edge, to fasten the second structural member to the substrate, and prevent the second structural member from moving on or falling off the surface of the substrate.

With reference to the first aspect, in some implementations of the first aspect, the first bending part and/or the second bending part are/is of a stepped shape.

In embodiments of this application, the first structural member may be connected to the substrate via the first bending part of a stepped shape, to increase a contact area at a connection to the substrate. This can adjust stress of the substrate, and avoid warpage (warpage) or deformation of the substrate. Similarly, the second structural member may be connected to the substrate via the second bending part of a stepped shape, to increase a contact area at a connection to the substrate. This can adjust stress of the substrate, and avoid warpage or deformation of the substrate.

With reference to the first aspect, in some implementations of the first aspect, the first structural member includes a first protrusion structure protruding toward the substrate, and the first protrusion structure is connected to the substrate; and/or the second structural member includes a second protrusion structure protruding toward the substrate, and the second protrusion structure is connected to the substrate.

In embodiments of this application, in addition to the first bending part, the first structural member may be further connected to the substrate via the first protrusion structure, to adjust stress of the substrate, and avoid warpage or deformation of the substrate. Similarly, the second structural member may also be connected to the substrate via the second bending part and the second protrusion structure, to adjust stress of the substrate.

With reference to the first aspect, in some implementations of the first aspect, the second structural member is provided with an opening, and the first structural member is located in the opening of the second structural member.

With reference to the first aspect, in some implementations of the first aspect, the package further includes a third die, the third die is disposed on the substrate, and the third die is located in the region of the orthographic projection of the first structural member or the second structural member on the surface of the substrate.

In embodiments of this application, dies whose performance (for example, power consumption and/or junction temperature specifications) differs slightly may be grouped into one group. Therefore, when the package includes a plurality of dies, a quantity of structural members may be reduced, to avoid a case in which impact of thermal crosstalk between the dies cannot be reduced because an air gap cannot be disposed between the large quantity of structural members.

With reference to the first aspect, in some implementations of the first aspect, the package further includes a first heat sink, the first heat sink is disposed on a side that is of the first structural member and that is away from the substrate, and a surface that is of the first heat sink and that is close to the substrate is connected to a surface that is of the first structural member and that is away from the substrate.

In embodiments of this application, heat dissipated by the first die may be transferred to the first structural member, and heat dissipated by the first structural member may be transferred to the first heat sink, so that the first heat sink may assist the first die in heat dissipation.

With reference to the first aspect, in some implementations of the first aspect, the first heat sink is not in contact with the second structural member.

In embodiments of this application, the first heat sink and the second structural member are neither directly connected nor in direct contact, so that the first heat sink can be used to assist only the first die in heat dissipation. This avoids exchange of heat dissipated by the first die and heat dissipated by the second die, and further reduces impact of thermal crosstalk between the dies.

With reference to the first aspect, in some implementations of the first aspect, the package further includes a second heat sink, the second heat sink is disposed on a side that is of the second structural member and that is away from the substrate, and a surface that is of the second heat sink and that is close to the substrate is connected to a surface that is of the second structural member and that is away from the substrate.

In embodiments of this application, heat dissipated by the second die may be transferred to the second structural member, and heat dissipated by the second structural member may be transferred to the second heat sink, so that the second heat sink may assist the second die in heat dissipation.

With reference to the first aspect, in some implementations of the first aspect, the second heat sink is not in contact with the first structural member.

In embodiments of this application, the second heat sink and the first structural member are neither directly connected nor in direct contact, so that the second heat sink can be used to assist only the second die in heat dissipation. This avoids exchange of heat dissipated by the first die and heat dissipated by the second die, and further reduces impact of thermal crosstalk between the dies.

With reference to the first aspect, in some implementations of the first aspect, there is an air gap between the first heat sink and the second heat sink.

In embodiments of this application, the first heat sink and the second heat sink are neither directly connected nor in direct contact, so that no heat is exchanged between the first heat sink and the second heat sink. This can reduce impact of thermal crosstalk between the dies.

With reference to the first aspect, in some implementations of the first aspect, the second heat sink includes a first heat dissipation part and a second heat dissipation part, a surface that is of the first heat dissipation part and that is close to the substrate is connected to the surface that is of the second structural member and that is away from the substrate, and the second heat dissipation part and the first heat dissipation part are disposed at an included angle on a plane parallel to the substrate.

In embodiments of this application, the first heat dissipation part and the second heat dissipation part may be disposed on the second heat sink, to increase a heat dissipation area and improve heat dissipation effect. In addition, the included angle between the first heat dissipation part and the second heat dissipation part may be adjusted, so that heat dissipation paths of the second heat sink and the first heat sink do not affect each other. This further improves heat dissipation effect.

With reference to the first aspect, in some implementations of the first aspect, the second heat sink forms a first avoidance space, and the first heat sink is located in the first avoidance space.

In embodiments of this application, the first heat sink may be disposed in the first avoidance space of the second heat sink, so that the heat dissipation paths of the two heat sinks do not affect each other, and the space can be properly used. This reduces an overall size of the package.

With reference to the first aspect, in some implementations of the first aspect, the first heat sink includes a protrusion part protruding toward the substrate, and the protrusion part is accommodated in the first avoidance space.

With reference to the first aspect, in some implementations of the first aspect, a surface that is of the protrusion part and that is close to the substrate is connected to the surface that is of the first structural member and that is away from the substrate.

In embodiments of this application, the first heat sink may be connected to the first structural member via the protrusion part accommodated in the first avoidance space, to assist the first die in heat dissipation. The first heat sink may further include a part other than the protrusion part, to increase a heat dissipation area and improve heat dissipation effect.

According to a second aspect, a chip is provided. The chip includes the package in the first aspect or any possible implementation of the first aspect.

According to a third aspect, an electronic apparatus is provided. The electronic apparatus includes the package in the first aspect or any possible implementation of the first aspect. Alternatively, the electronic apparatus includes the chip in the second aspect.

### BRIEF DESCRIPTION OF DRAWINGS

FIG. 1 is a cross-sectional view of a package;
FIG. 2 is a top view of a package according to an embodiment of this application;
FIG. 3 is a cross-sectional view of a package according to an embodiment of this application;
FIG. 4 is a cross-sectional view of a package according to another embodiment of this application;
FIG. 5 is a top view of a package according to another embodiment of this application;
FIG. 6 is a top view of a package according to another embodiment of this application;
FIG. 7 is a cross-sectional view of a package according to another embodiment of this application;
FIG. 8 is a top view of a package according to another embodiment of this application;
FIG. 9 is a cross-sectional view of a package according to another embodiment of this application;
FIG. 10 is a top view of a package according to another embodiment of this application;
FIG. 11 is a top view of a package according to another embodiment of this application;
FIG. 12 is a cross-sectional view of a package according to another embodiment of this application;
FIG. 13 is a top view of a package according to another embodiment of this application;
FIG. 14 is a diagram of structures of heat sinks according to an embodiment of this application; and
FIG. 15 is a diagram of structures of heat sinks and connecting members according to an embodiment of this application.

### DESCRIPTION OF EMBODIMENTS

The following describes technical solutions in embodiments of this application with reference to accompanying drawings.

In embodiments of this application, the term such as "example" or "for example" represents giving an example, an illustration, or a description. Any embodiment or design solution described as an "example" in embodiments of this application should not be construed as being more preferred or having more advantages than another embodiment or design solution. Specifically, the word example is used to present a concept in a specific manner.

A service scenario described in embodiments of this application is intended to describe the technical solutions in embodiments of this application more clearly, but does not constitute a limitation on the technical solutions provided in embodiments of this application. A person of ordinary skill in the art may learn that as the technologies evolve, the technical solutions provided in embodiments of this application are also applicable to a similar technical problem.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

In embodiments of this application, "at least one" means one or more, and "plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" usually indicates an "or" relationship between the associated objects. "At least one of the following items (pieces)" or a similar expression thereof refers to any combination of these items, including any combination of singular items (pieces) or plural items (pieces). For example, at least one item (piece) of a, b, or c may indicate: a, b, c, a and b, a and c, b and c, or a, b, and c, where a, b, and c may be singular or plural.

The technical solutions in embodiments of this application may be applied to a package or a chip including a plurality of dies. A type of each of the plurality of dies is not limited in embodiments of this application. For example, the die may be a logic chip, a high bandwidth memory (high bandwidth memory, HBM), or the like.

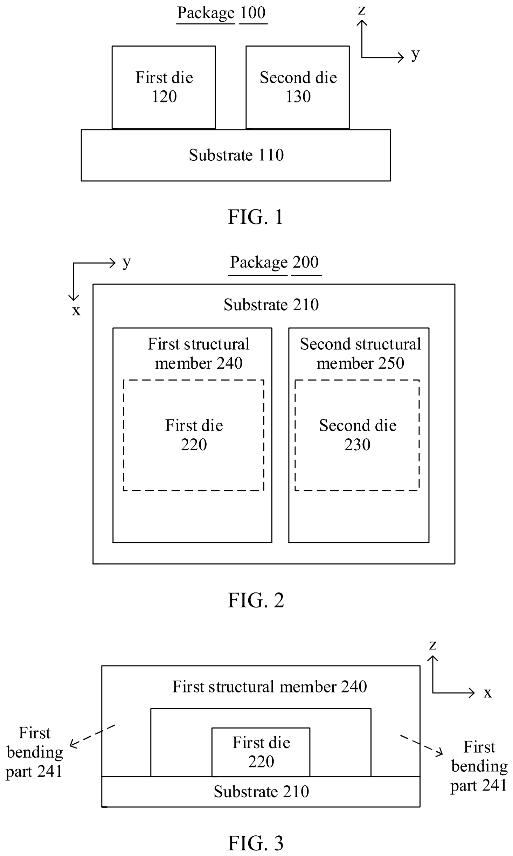

FIG. 1 is a diagram of a package. A package 100 in FIG. 1 includes a substrate 110, a first die 120, and a second die 130. For example, the first die 120 or the second die 130 may be a logic chip or an HBM. The first die 120 and the second die 130 are disposed on the substrate 110 and are connected to the substrate 110. Both the first die 120 and the second die 130 generate heat during operation, resulting in thermal crosstalk between the two dies.

In FIG. 1, a direction from the first die 120 to the second die 130 is a y-axis direction, and a direction from the substrate 110 to the first die 120 is a z-axis direction.

FIG. 2 is a top view of a package according to an embodiment of this application. A package 200 in FIG. 2 includes a substrate 210, a first die 220, a second die 230, a first structural member 240, and a second structural member 250. The first die 220, the second die 230, the first structural member 240, and the second structural member 250 are all disposed on the substrate 210.

As shown in FIG. 2, a direction from the first die 220 to the second die 230 is a y-axis direction, and a direction perpendicular to the y-axis direction on a plane on which the substrate 210 is located is an x-axis direction. In addition, a direction from the substrate 210 to the first die 220 is a z-axis direction (not shown in FIG. 2).

A specific type of the substrate 210 is not limited in embodiments of this application. For example, the substrate 210 may be a base or a printed circuit board (printed circuit board, PCB).

In embodiments of this application, specific types of the first die 220 and the second die 230 are not limited. For example, the first die 220 and/or the second die 230 may be a logic chip or an HBM. The first die 220 and the second die 230 may be dies of a same type or different types. The package 200 may include a plurality of first dies and/or a plurality of second dies.

A first dielectric material may be filled between the first die 220 and the second die 230, that is, the first die 220 and the second die 230 are neither directly connected nor in direct contact. The first die 220 and the second die 230 may be fastened via the first dielectric material, so that the first die 220 and the second die 230 are hard to move. The first dielectric material may be further used to perform heat insulation, to avoid exchange of heat dissipated by the first die 220 and heat dissipated by the second die 230. In embodiments of this application, a specific type or composition of the first dielectric material is not limited.

In some embodiments, an upper surface of the first die 220 and/or an upper surface of the second die 230 may be planar or non-planar. The upper surface of the first die 220 is a surface that is of the first die 220 and that is away from the substrate 210. The upper surface of the second die 230 is a surface that is of the second die 230 and that is away from the substrate 210.

When the upper surfaces of the first die 220 and the second die 230 are planar, a height from the upper surface of the first die 220 to an upper surface of the substrate 210 may be the same as or different from a height from the upper surface of the second die 230 to the upper surface of the substrate 210. This is not limited in embodiments of this application.

The first structural member 240 is disposed on a side that is of the first die 220 and that is away from the substrate 210. In other words, in the z-axis direction, the substrate 210 is disposed at a bottom layer, the first die 220 is disposed at an upper layer of the substrate 210, and the first structural member 240 is disposed at an upper layer of the first die 220. The first die 220 is located in a region of orthographic projection of the first structural member 240 on a surface of the substrate 210. The orthographic projection is projection generated by parallel projection lines perpendicular to the substrate 210, and the region of orthographic projection is a region formed by the orthographic projection. In other words, the upper surface of the first die 220 may be covered by the orthographic projection of the first structural member 240 on the substrate 210.

The first structural member 240 may be configured to conduct heat or dissipate heat, and thereby configured to receive heat from the first die 220. A specific material of the first structural member 210 is not limited in embodiments of this application.

In some embodiments, a first thermally conductive material is filled between the first structural member 240 and the first die 220. The first thermally conductive material is configured to transfer heat emitted by the first die 220 to the first structural member 240. In embodiments of this application, a specific type or composition of the first thermally conductive material is not limited.

The second structural member 250 is disposed on a side that is of the second die 230 and that is away from the substrate 210. In other words, in the z-axis direction, the substrate 210 is disposed at a bottom layer, the second die 230 is disposed at the upper layer of the substrate 210, and the second structural member 250 is disposed at an upper layer of the second die 230. The second die 230 is located in a region of orthographic projection of the second structural member 250 on a surface of the substrate 210. In other words, the upper surface of the second die 230 may be covered by the orthographic projection of the second structural member 250 on the substrate 210.

The second structural member 250 may be configured to conduct heat or dissipate heat, and thereby configured to receive heat from the second die 230. A specific material of the second structural member 250 is not limited in embodiments of this application. The first structural member 240 and the second structural member 250 may be made of a same material or different materials. This is not limited in embodiments of this application. The package 200 may include a plurality of first structural members and/or a plurality of second structural members, and there is an air gap between structural members.

In some embodiments, a second thermally conductive material is filled between the second structural member 250 and the second die 230. The second thermally conductive material is configured to transfer heat emitted by the second die 230 to the second structural member 250. In embodiments of this application, a specific type or composition of the second thermally conductive material is not limited. The first thermally conductive material and the second thermally conductive material may be the same or different.

There is an air gap between the first structural member 240 and the second structural member 250. In other words, the first structural member 240 and the second structural member 250 are neither directly connected nor in direct contact, to implement heat insulation. This avoids heat exchange between the first die 220 and the second die 230, that is, reduces impact of thermal crosstalk between the first die 220 and the second die 230.

In some embodiments, an upper surface of the first structural member 240 and/or an upper surface of the second structural member 250 may be planar or non-planar. The upper surface of the first structural member 240 is a surface that is of the first structural member 240 and that is away from the substrate 210. The upper surface of the second structural member 250 is a surface that is of the second structural member 250 and that is away from the substrate 210.

When the upper surfaces of the first structural member 240 and the second structural member 250 are planar, a height from the upper surface of the first structural member 240 to the upper surface of the substrate 210 may be the same as or different from a height from the upper surface of the second structural member 250 to the upper surface of the substrate 210. This is not limited in embodiments of this application.

Optionally, an edge of the first structural member 240 may include a first bending part bent toward the substrate 210, and the first bending part is connected to the substrate 210.

In some embodiments, the first structural member 240 may include at least one first bending part, and each first bending part may be bent toward the substrate 210. Each first bending part may be connected to the substrate 210.

In some embodiments, a tangent plane of the first bending part to a plane of an x axis and a z axis may be of a straight line, as shown in FIG. 3. When the tangent plane of the first bending part to the plane of the x axis and the z axis is of a straight line, the first bending part and the substrate may be disposed at an included angle, and the included angle may be an acute angle, a right angle, or an obtuse angle.

FIG. 3 is a cross-sectional view of a package according to an embodiment of this application. FIG. 3 is a diagram of the tangent plane to the plane of the x axis and the z axis. In FIG. 3, the substrate 210, the first die 220, and the first structural member 240 are included. The first die 220 is disposed on the substrate 210, and is located in the region of the orthographic projection of the first structural member 240 on the surface of the substrate 210. Two edges of the first structural member 240 each include one first bending part 241, and each first bending part 241 is bent toward the substrate 210. A tangent plane of each first bending part 241 to the plane of the x axis and the z axis is of a straight line, and each first bending part 241 and the substrate 210 are disposed at a right angle. In other words, each first bending part 241 may be vertically connected to the substrate 210 in a straight line.

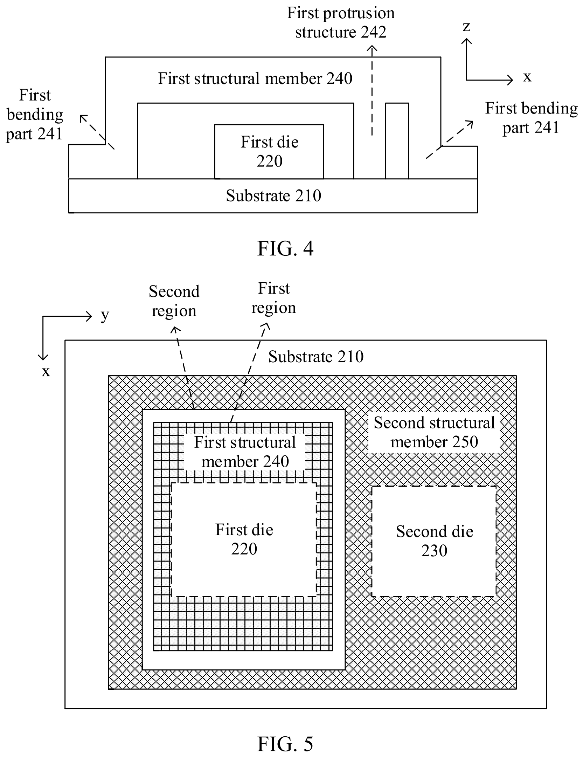

In some embodiments, the tangent plane of the first bending part to the plane of the x axis and the z axis may be of a non-straight line, and the non-straight line shape includes a fold-line shape and a curve shape. FIG. 4 is a diagram in which the tangent plane of the first bending part to the plane of the x axis and the z axis is of a fold-line shape.

FIG. 4 is another cross-sectional view of a package according to an embodiment of this application. FIG. 4 is a diagram of the tangent plane to the plane of the x axis and the z axis. In FIG. 4, the substrate 210, the first die 220, and the first structural member 240 are included. The first die 220 is disposed on the substrate 210, and is located in the region of the orthographic projection of the first structural member 240 on the surface of the substrate 210. Two edges of the first structural member 240 each include one first bending part 241, and each first bending part 241 is bent toward the substrate 210. Each first bending part 241 is of a stepped shape, and a bottom of each first bending part 241 in the z-axis direction is connected to the substrate 210. In other words, each first bending part 241 may be in an "L" shape, and a bottom of the "L" shape is connected to the substrate 210, that is, a tangent plane of each first bending part 241 to the plane of the x axis and the z axis is of a fold-line shape.

When the first structural member 240 includes a plurality of first bending parts, the first bending parts may be of a same shape. Alternatively, shapes of at least two of the plurality of first bending parts may be different. This is not limited in this embodiment of this application.

Optionally, an edge of the second structural member 250 may include a second bending part bent toward the substrate 210, and the second bending part is connected to the substrate 210.

In some embodiments, the second structural member 250 may include at least one second bending part, and each second bending part may be of a same shape. Alternatively, shapes of at least two of a plurality of second bending parts may be different.

In some embodiments, a tangent plane, similar to that of the first bending part, of the second bending part to the plane of the x axis and the z axis may be of a straight line or non-straight line. For example, the second bending part may be similar to the first bending part 241 in FIG. 3 or FIG. 4. Details are not described herein again.

When the first structural member 240 includes one first bending part and the second structural member 250 includes one second bending part, the first bending part and the second bending part may be of a same shape or different shapes. When the first structural member 240 includes one first bending part and the second structural member 250 includes a plurality of second bending parts, the first bending part may have a same shape as or a different shape from at least one of the plurality of second bending parts. Similarly, when the first structural member 240 includes a plurality of first bending parts and the second structural member 250 includes one second bending part, the second bending part may have a same shape as or a different shape from at least one of the plurality of first bending parts. When the first structural member 240 includes a plurality of first bending parts and the second structural member 250 includes a plurality of second bending parts, each first bending part may have a same shape as or a different shape from at least one of the plurality of second bending parts.

Optionally, the first structural member 240 may include a first protrusion structure protruding toward the substrate 210, and the first protrusion structure is connected to the substrate 210.

In some embodiments, the first structural member 240 may include at least one first protrusion structure. Each of the at least one first protrusion structure is connected to the substrate 210.

In some embodiments, a tangent plane of the first protrusion structure to the plane of the x axis and the z axis may be of a straight line, as shown in FIG. 4. When the tangent plane of the first protrusion structure to the plane of the x axis and the z axis is of a straight line, the first protrusion structure and the substrate may be disposed at an included angle, and the included angle may be an acute angle, a right angle, or an obtuse angle.

As shown in FIG. 4, the first structural member 240 in FIG. 4 further includes one first protrusion structure 242. The first protrusion structure 242 protrudes toward the substrate 210. A tangent plane of the first protrusion structure 242 to the plane of the x axis and the z axis is of a straight line, and the first protrusion structure 242 and the substrate 210 are disposed at a right angle. In other words, the first protrusion structure 242 may be vertically connected to the substrate 210 in a straight line.

In some embodiments, the tangent plane of the first protrusion structure to the plane of the x axis and the z axis may be of a non-straight line, and the non-straight line shape includes a fold-line shape and a curve shape. When the tangent plane of the first protrusion structure to the plane of the x axis and the z axis is of a fold-line shape, the first protrusion structure is similar to the structure of the first bending part 241 shown in FIG. 4. Details are not described herein again.

When the first structural member 240 includes a plurality of first protrusion structures, the first protrusion structures may be of a same shape. Alternatively, shapes of at least two of the plurality of first protrusion structures may be different. This is not limited in this embodiment of this application.

Optionally, the second structural member 250 may include a second protrusion structure protruding toward the substrate 210, and the second protrusion structure is connected to the substrate 210.

In some embodiments, the second structural member 250 may include at least one second protrusion structure, and each second protrusion structure may be of a same shape. Alternatively, shapes of at least two of a plurality of second protrusion structures may be different.

In some embodiments, a tangent plane, similar to that of the first protrusion structure, of the second protrusion structure to the plane of the x axis and the z axis may be of a straight line or non-straight line. For example, the second protrusion structure may be similar to the first protrusion structure 242 or the first bending part 241 in FIG. 4. Details are not described herein again.

When the first structural member 240 includes one first protrusion structure and the second structural member 250 includes one second protrusion structure, the first protrusion structure and the second protrusion structure may be of a same shape or different shapes. When the first structural member 240 includes one first protrusion structure and the second structural member 250 includes a plurality of second protrusion structures, the first protrusion structure may have a same shape as or a different shape from at least one of the plurality of second protrusion structures. Similarly, when the first structural member 240 includes a plurality of first protrusion structures and the second structural member 250 includes one second protrusion structure, the second protrusion structure may have a same shape as or a different shape from at least one of the plurality of first protrusion structures. When the first structural member 240 includes a plurality of first protrusion structures and the second structural member 250 includes a plurality of second protrusion structures, each first protrusion structure may have a same shape as or a different shape from at least one of the plurality of second protrusion structures.

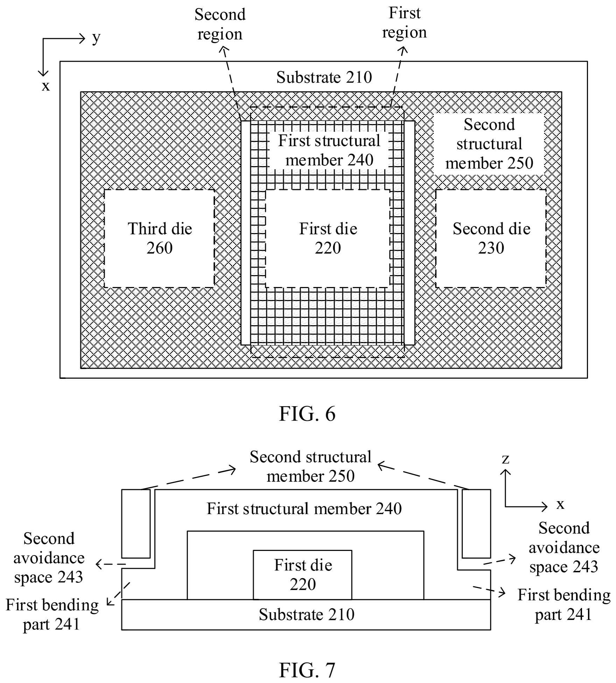

Optionally, the region of the orthographic projection of the first structural member 240 on the surface of the substrate 210 may partially overlap or not overlap the region of the orthographic projection of the second structural member 250 on the surface of the substrate 210. FIG. 2 or FIG. 5 shows that the region of the orthographic projection of the first structural member 240 on the surface of the substrate 210 does not overlap the region of the orthographic projection of the second structural member 250 on the surface of the substrate 210. FIG. 6 shows that the region of the orthographic projection of the first structural member 240 on the surface of the substrate 210 partially overlaps the region of the orthographic projection of the second structural member 250 on the surface of the substrate 210.

In some embodiments, the first structural member 240 and the second structural member 250 may be disposed side by side, so that the region of the orthographic projection of the first structural member 240 on the surface of the substrate 210 does not overlap the region of the orthographic projection of the second structural member 250 on the surface of the substrate 210, as shown in FIG. 2.

In some embodiments, the second structural member 250 may be provided with an opening, and the first structural member 240 may be located in the opening of the second structural member 250, so that the region of the orthographic projection of the first structural member 240 on the surface of the substrate 210 partially overlaps or does not overlap the region of the orthographic projection of the second structural member 250 on the surface of the substrate 210, as shown in FIG. 5 or FIG. 6.

FIG. 5 is a top view of a package according to an embodiment of this application. In FIG. 5, the substrate 210, the first die 220, the second die 230, the first structural member 240, and the second structural member 250 are included. The region of the orthographic projection of the first structural member 240 on the surface of the substrate 210 is a first region, and a region of orthographic projection of the opening of the second structural member 250 on the surface of the substrate 210 is a second region. The first die 220 is located in the first region. The second die 230 is located in a region of orthographic projection, on the surface of the substrate 210, of a part of the second structural member 250 other than the opening. The first region is located in the second region. A length of the first region in the x-axis direction is less than a length of the second region in the x-axis direction, and a length of the first region in the y-axis direction is less than a length of the second region in the y-axis direction. In other words, an area of the first region is less than an area of the second region, that is, the region of the orthographic projection of the first structural member 240 on the surface of the substrate 210 does not overlap the region of the orthographic projection of the second structural member 250 on the surface of the substrate 210.

FIG. 6 is a top view of a package according to an embodiment of this application. In FIG. 6, the substrate 210, the first die 220, the second die 230, the first structural member 240, and the second structural member 250 are included. The region of the orthographic projection of the first structural member 240 on the surface of the substrate 210 is a first region, and a region of orthographic projection of the opening of the second structural member 250 on the surface of the substrate 210 is a second region. The first die 220 is located in the first region. The second die 230 is located in a region of orthographic projection, on the surface of the substrate 210, of a part of the second structural member 250 other than the opening. A part of the first region is located inside the second region, and the other part of the first region is located in the second region. A length of the first region in the x-axis direction is greater than or equal to a length of the second region in the x-axis direction, that is, the region of the orthographic projection of the first structural member 240 on the surface of the substrate 210 partially overlaps the region of the orthographic projection of the second structural member 250 on the surface of the substrate 210.

For example, when the region of the orthographic projection of the first structural member 240 on the surface of the substrate 210 partially overlaps the region of the orthographic projection of the second structural member 250 on the surface of the substrate 210, the length of the first region in the x-axis direction may be greater than or equal to the length of the second region in the x-axis direction, as shown in FIG. 6. Alternatively, when the region of the orthographic projection of the first structural member 240 on the surface of the substrate 210 partially overlaps the region of the orthographic projection of the second structural member 250 on the surface of the substrate 210, a length of the first region in the y-axis direction may be greater than or equal to a length of the second region in the y-axis direction. Alternatively, when the region of the orthographic projection of the first structural member 240 on the surface of the substrate 210 partially overlaps the region of the orthographic projection of the second structural member 250 on the surface of the substrate 210, an area of the first region may be greater than or equal to an area of the second region.

FIG. 7 is a cross-sectional view of a package when the region of the orthographic projection of the first structural member 240 on the surface of the substrate 210 partially overlaps the region of the orthographic projection of the second structural member 250 on the surface of the substrate 210. FIG. 7 is a cross-sectional view of a package according to an embodiment of this application. FIG. 7 is a diagram of a tangent plane to a plane of the x axis and the z axis. In FIG. 7, the substrate 210, the first die 220, the first structural member 240, and the second structural member 250 are included. The first die 220 is located in a region of orthographic projection of the first structural member 240 on a surface of the substrate 210. The edge of the first structural member 240 includes the first bending part 241, and the first bending part 241 is of a stepped shape. The first bending part 241 forms a second avoidance space 243, and the second avoidance space 243 is located on a side that is of the first bending part 241 and that is away from the first die 220. An edge part of the second structural member 250 may be accommodated in the second avoidance space 243. In addition, there is an air gap between the edge part of the second structural member 250 and the first bending part 241, that is, the edge part of the second structural member 250 and the first bending part 241 are neither directly connected nor in direct contact.

Optionally, the package 200 may further include at least one third die. The third die may be disposed on the substrate 210. The third die is located in the region of the orthographic projection of the first structural member 240 or the second structural member 250 on the surface of the substrate 210. In other words, at least one die may be disposed in the region of the orthographic projection of the first structural member 240 or the second structural member 250 on the surface of the substrate 210. A specific type, similar to that of the first die 220 and that of the second die 230, of the third die is not limited in embodiments of this application. The type of the third die may be the same as or different from the type of the first die 220 and/or the type of the second die 230.

When the third die is disposed in the region of the orthographic projection of the second structural member 250 on the surface of the substrate 210, the third die and the second die 230 may be disposed on a same side or different sides of the first die 220. This is not limited in this embodiment of this application.

For example, the third die may be disposed on a side that is of the first die 220 and that is away from the second die 230, as shown in FIG. 6. FIG. 6 further includes a third die 260. The third die 260 is disposed in the region of the orthographic projection of the second structural member 250 on the surface of the substrate 210. In addition, the first die 220 is disposed between the second die 230 and the third die 260.

In some embodiments, specific locations of the first die, the second die, and the third die may be determined based on any one or more properties such as power consumption, junction temperature specifications, and heights of the first die, the second die, and the third die. The junction temperature specification of each die may include a specification of a maximum temperature at which each die operates for a long time, a specification of a maximum temperature for extreme operating of each die, a specification of a high-reliability recommended temperature of each die, or the like. This is not limited in embodiments of this application. It should be understood that the specific locations of the first die, the second die, and the third die may be determined based on other properties or other performance of the first die, the second die, and the third die. Specific properties or specific performance is not limited in embodiments of this application.

For example, it is assumed that a difference between power consumption of the third die 260 and power consumption of the first die 220 is less than a first preset threshold. In this case, the third die 260 and the first die 220 may be disposed in the region of the orthographic projection of the first structural member 240 on the surface of the substrate 210. Alternatively, it is assumed that a difference between junction temperature specifications of the third die 260 and the first die 220 is less than a second preset threshold. In this case, the third die 260 and the first die 220 may be disposed in the region of the orthographic projection of the first structural member 240 on the surface of the substrate 210. Alternatively, it is assumed that the difference between the power consumption of the third die 260 and the power consumption of the first die 220 is less than the first preset threshold, and the difference of junction temperature specifications between the third die 260 and the first die 220 is less than the second preset threshold. In this case, the third die and the first die 220 may be disposed in the region of the orthographic projection of the first structural member 240 on the surface of the substrate 210. For example, it is assumed that both heights of the third die 260 and the first die 220 are less than a third preset threshold, and a height of the second die 230 is greater than or equal to the third preset threshold. In this case, the third die and the first die 220 may be disposed in the region of the orthographic projection of the first structural member 240 on the surface of the substrate 210. Specific values of the first preset threshold, the second preset threshold, and the third preset threshold are not limited in embodiments of this application, and may be set based on an actual requirement. The first preset threshold, the second preset threshold, and the third preset threshold may be the same, or at least two of the first preset threshold, the second preset threshold, and the third preset threshold may be different.

In some embodiments, parameters such as a material, a size, and a thermal conductivity coefficient of a structural member corresponding to each die may be adjusted based on any one or more properties such as power consumption, a junction temperature specification, or a height of the die, to adjust a heat dissipation resource corresponding to each die as required. This implement better heat dissipation effect without wasting the heat dissipation resource. For example, parameters such as a material, a size, and a thermal conductivity coefficient of the first structural member may be adjusted based on any one or more properties such as a function, a junction temperature specification, or a height of the first die, to implement better heat dissipation effect.

Optionally, the package 200 may further include at least one first heat sink. The first heat sink is disposed on a side that is of the first structural member 240 and that is away from the substrate 210, and a surface that is of the first heat sink and that is close to the substrate 210 is connected to a surface that is of the first structural member 240 and that is away from the substrate 210. The first heat sink may receive heat from the first structural member 240, to assist the first die 220 in heat dissipation.

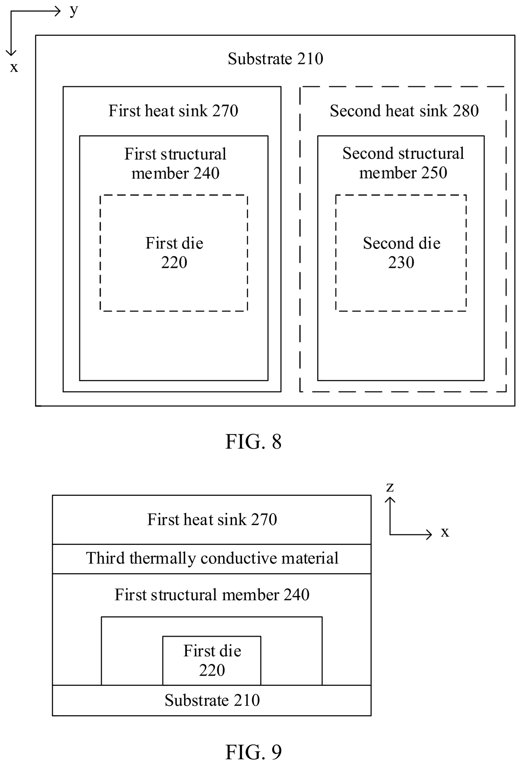

In some embodiments, the region of the orthographic projection of the first structural member 240 on the surface of the substrate 210 partially overlaps a region of orthographic projection of the first heat sink on the surface of the substrate 210. A relationship between sizes of the region of the orthographic projection of the first heat sink on the surface of the substrate 210 and the region of the orthographic projection of the first structural member 240 on the surface of the substrate 210 is not limited in embodiments of this application. For example, an area of the region of the orthographic projection of the first heat sink on the surface of the substrate 210 may be less than or equal to an area of the region of the orthographic projection of the first structural member 240 on the surface of the substrate 210. Alternatively, the area of the region of the orthographic projection of the first heat sink on the surface of the substrate 210 may be greater than the area of the region of the orthographic projection of the first structural member 240 on the surface of the substrate 210, as shown in FIG. 8.

FIG. 8 is a top view of a package according to an embodiment of this application. In FIG. 8, the substrate 210, the first die 220, the first structural member 240, and a first heat sink 270 are included. The first die 220 is located in the region of the orthographic projection of the first structural member 240 on the surface of the substrate 210, and the first structural member 240 is located in the orthographic projection of the first heat sink 270 on the surface of the substrate 210.

In some embodiments, the first heat sink 270 is not in contact with the second structural member 250. In other words, the first heat sink 270 and the second structural member 250 are neither in direct contact nor indirect contact, so that the first heat sink 270 does not receive heat from the second die 230. This reduces impact of thermal crosstalk between the first die 220 and the second die 230.

In some embodiments, the region of the orthographic projection of the second structural member 250 on the surface of the substrate 210 partially overlaps or does not overlap the region of the orthographic projection of the first heat sink 270 on the surface of the substrate 210. When the region of the orthographic projection of the second structural member 250 on the surface of the substrate 210 partially overlaps the region of the orthographic projection of the first heat sink on the surface of the substrate 210, there is an air gap in a part in which the second structural member 250 and the first heat sink 270 are close. FIG. 8 shows that the region of the orthographic projection of the second structural member 250 on the surface of the substrate 210 does not overlap the region of the orthographic projection of the first heat sink 270 on the surface of the substrate 210.

As shown in FIG. 8, the second die 230 and the second structural member 250 are further included FIG. 8. The second die 230 is located in the region of the orthographic projection of the second structural member 250 on the surface of the substrate 210. The second structural member 250 and the first structural member 240 are disposed side by side, and there is an air gap in a part in which the second structural member 250 and the first structural member 240 are close, so that the region of the orthographic projection of the second structural member 250 on the surface of the substrate 210 does not overlap the region of the orthographic projection of the first heat sink 270 on the surface of the substrate 210.

In some embodiments, the first heat sink 270 is directly connected to the first structural member 240. Alternatively, the first heat sink 270 is connected to the first structural member 240 via a third thermally conductive material, as shown in FIG. 9.

FIG. 9 is a cross-sectional view of a package according to an embodiment of this application. FIG. 9 is a diagram of a tangent plane to a plane of the x axis and the z axis. In FIG. 9, the substrate 210, the first die 220, the first structural member 240, the third thermally conductive material, and the first heat sink 270 are included. In the z-axis direction, the substrate 210 is located at the bottom layer, the first die 220 and the first structural member 240 are location at an upper layer of the substrate 210, and the first die 220 is located in the region of the orthographic projection of the first structural member 240 on the surface of the substrate 210. The third thermally conductive material is located on an upper layer of the first structural member 240, and may be used to connect the first structural member 240 to the first heat sink 270. In other words, the first heat sink 270 is located at an upper layer of the third thermally conductive material. The third thermally conductive material may be used to transfer heat of the first structural member 240 to the first heat sink 270, to assist the first die 220 in heat dissipation. In embodiments of this application, a specific type or composition of the third thermally conductive material is not limited.

Optionally, the package 200 may further include at least one second heat sink. The second heat sink is disposed on a side that is of the second structural member 250 and that is away from the substrate 210, and a surface that is of the second heat sink and that is close to the substrate 210 is connected to a surface that is of the second structural member 250 and that is away from the substrate 210. The second heat sink may receive heat from the second structural member 250, to assist the second die 230 in heat dissipation.

In some embodiments, the region of the orthographic projection of the second structural member 250 on the surface of the substrate 210 partially overlaps a region of orthographic projection of the second heat sink on the surface of the substrate 210. A relationship between sizes of the region of the orthographic projection of the second heat sink on the surface of the substrate 210 and the region of the orthographic projection of the second structural member 250 on the surface of the substrate 210 is not limited in embodiments of this application. For example, an area of the region of the orthographic projection of the second heat sink on the surface of the substrate 210 may be less than or equal to an area of the region of the orthographic projection of the second structural member 250 on the surface of the substrate 210. Alternatively, the area of the region of the orthographic projection of the second heat sink on the surface of the substrate 210 may be greater than the area of the region of the orthographic projection of the second structural member 250 on the surface of the substrate 210, as shown in FIG. 8.

In FIG. 8, a second heat sink 280 is further included. In FIG. 8, the second die 230 is located in the region of the orthographic projection of the second structural member 250 on the surface of the substrate 210, and the second structural member 250 is located in the orthographic projection of the second heat sink 280 on the surface of the substrate 210.

In some embodiments, the second heat sink 280 is not in contact with the first structural member 240. In other words, the second heat sink 280 and the first structural member 240 are neither in direct contact nor indirect contact, so that the second heat sink 280 does not receive heat from the first die 220. This reduces impact of thermal crosstalk between the first die 220 and the second die 230.

In some embodiments, the region of the orthographic projection of the first structural member 240 on the surface of the substrate 210 partially overlaps or does not overlap the region of the orthographic projection of the second heat sink 280 on the surface of the substrate 210. When the region of the orthographic projection of the first structural member 240 on the surface of the substrate 210 partially overlaps the region of the orthographic projection of the second heat sink 280 on the surface of the substrate 210, there is an air gap between the first structural member 240 and the second heat sink 280. FIG. 8 shows that the region of the orthographic projection of the first structural member 240 on the surface of the substrate 210 does not overlap the region of the orthographic projection of the second heat sink 280 on the surface of the substrate 210. In FIG. 8, the second structural member 250 and the first structural member 240 are disposed side by side, and the region of the orthographic projection of the first structural member 240 on the surface of the substrate 210 does not overlap the region of the orthographic projection of the second heat sink 280 on the surface of the substrate 210.

In some embodiments, the second heat sink 280 is directly connected to the second structural member 250. Alternatively, the second heat sink 280 is connected to the second structural member 250 via a fourth thermally conductive material. A manner of connecting the second heat sink 280 to the second structural member 250 via the fourth thermally conductive material is similar to the manner shown in FIG. 9. Details are not described herein again. The fourth thermally conductive material may be used to transfer heat of the second structural member 250 to the second heat sink 280, to assist the second die 230 in heat dissipation. In embodiments of this application, a specific type or composition of the fourth thermally conductive material is not limited.

It should be understood that the first thermally conductive material, the second thermally conductive material, the third thermally conductive material, and the fourth thermally conductive material may be a same thermally conductive material. Alternatively, at least two of the first thermally conductive material, the second thermally conductive material, the third thermally conductive material, and the fourth thermally conductive material are different thermally conductive materials. This is not limited in embodiments of this application.

In some embodiments, there is an air gap between the first heat sink 270 and the second heat sink 280. In other words, the first heat sink 270 the second heat sink 280 are neither directly connected nor in direct contact, so that the first heat sink 270 does not receive heat from the second heat sink 280. This reduces impact of thermal crosstalk between the first die 220 and the second die 230.

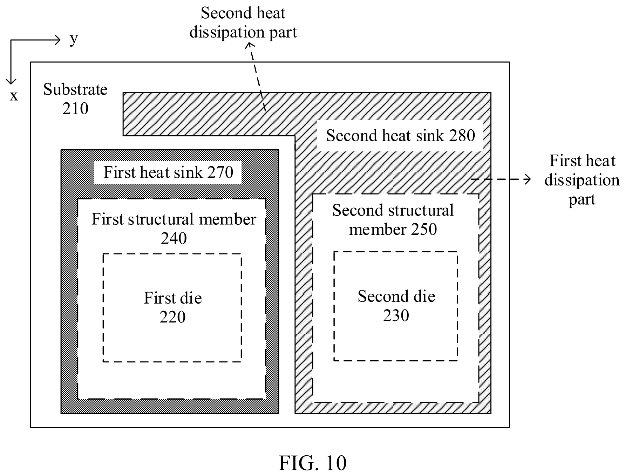

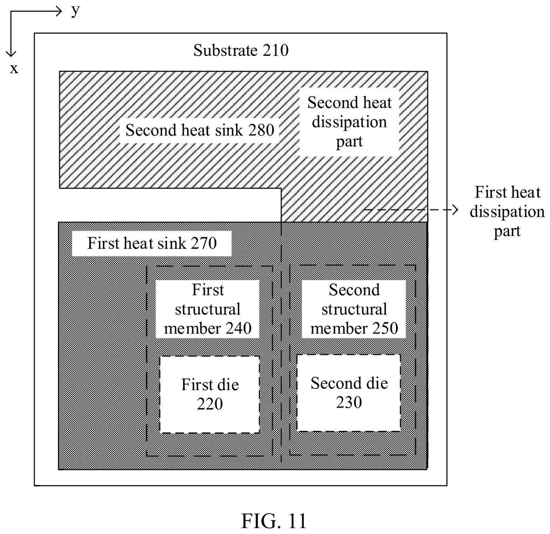

In some embodiments, the region of the orthographic projection of the first heat sink 270 on the surface of the substrate 210 partially overlaps or does not overlap the region of the orthographic projection of the second heat sink 280 on the surface of the substrate 210. For example, FIG. 8 or FIG. 10 shows that the region of the orthographic projection of the first heat sink 270 on the surface of the substrate 210 does not overlap the region of the orthographic projection of the second heat sink 280 on the surface of the substrate 210. FIG. 11, FIG. 12, or 13 shows that the region of the orthographic projection of the first heat sink 270 on the surface of the substrate 210 partially overlaps the region of the orthographic projection of the second heat sink 280 on the surface of the substrate 210.

In FIG. 8, the first heat sink 270 and the second heat sink 280 are disposed side by side, and there is an air gap in a part in which the first heat sink 270 and the second heat sink 280 are close, so that the region of the orthographic projection of the first heat sink 270 on the surface of the substrate 210 does not overlap the region of the orthographic projection of the second heat sink 280 on the surface of the substrate 210.

In some embodiments, the second heat sink may form a first avoidance space, and the first heat sink may be located in the first avoidance space. For example, an entire structure of the first heat sink may be located in the first avoidance space, so that the region of the orthographic projection of the first heat sink on the surface of the substrate does not overlap the region of the orthographic projection of the second heat sink on the surface of the substrate, as shown in FIG. 10. Alternatively, a part of the structure of the first heat sink may be located in the first avoidance space, and the other part of the structure of the first heat sink may be located on a side that is of the second heat sink and that is away from the substrate, so that the region of the orthographic projection of the first heat sink on the surface of the substrate partially overlaps the region of the orthographic projection of the second heat sink on the surface of the substrate, as shown in FIG. 11.

When the second heat sink may form the first avoidance space, the second heat sink may include a first heat dissipation part and a second heat dissipation part. The first heat dissipation part is connected to the surface that is of the second structural member and that is away from the substrate, and the second heat dissipation part and the first heat dissipation part are disposed at an included angle on a plane parallel to the substrate, as shown in FIG. 10, FIG. 11, and FIG. 13. The included angle may be an acute angle, a right angle, or an obtuse angle.

FIG. 10 is a top view of a package according to an embodiment of this application. In FIG. 10, the substrate 210, the first die 220, the second die 230, the first structural member 240, the second structural member 250, the first heat sink 270, and the second heat sink 280 are included. The second heat sink 280 may form the first avoidance space. In other words, the second heat sink 280 may include the first heat dissipation part and the second heat dissipation part, and the first heat dissipation part and the second heat dissipation part are disposed at an included angle, to form the first avoidance space. The first heat dissipation part is connected to the second structural member 250, that is, the surface that is of the first heat dissipation part and that is close to the substrate 210 is connected to the surface that is of the second structural member 250 and that is away from the substrate 210. The entire structure of the first heat sink 270 is located in the first avoidance space, and the first heat sink 270 is connected to the first structural member 240. There is an air gap between the first heat sink 270 and the second heat sink 280, so that the region of the orthographic projection of the first heat sink 270 on the surface of the substrate 210 does not overlap the region of the orthographic projection of the second heat sink 280 on the surface of the substrate 210.

In some embodiments, the second heat dissipation part of the second heat sink 280 may be or may not be connected to the second structural member 250. In other words, a surface that is of the second heat dissipation part and that is close to the substrate 210 may be or may not be connected to the surface that is of the second structural member 250 and that is away from the substrate 210.

When the second heat sink can form the first avoidance space, the first heat sink 270 may include a protrusion part protruding toward the substrate 210. The protrusion part can be accommodated in the first avoidance space, as shown in FIG. 11, FIG. 12, and FIG. 13.

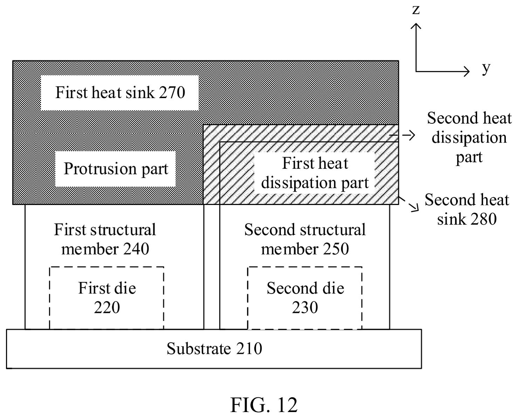

FIG. 11 is a top view of a package according to an embodiment of this application. In FIG. 11, the substrate 210, the first die 220, the second die 230, the first structural member 240, the second structural member 250, the first heat sink 270, and the second heat sink 280 are included. FIG. 12 is a cross-sectional view of the package in FIG. 11. FIG. 12 is a diagram of a tangent plane to a plane of the y axis and the z axis. In other words, the package in FIG. 11 is the same as that in FIG. 12.

As shown in FIG. 11 and FIG. 12, the second heat sink 280 may include the first heat dissipation part and the second heat dissipation part, and the first heat dissipation part and the second heat dissipation part are disposed at an included angle, to form the first avoidance space. The first heat dissipation part is connected to the second structural member 250, that is, the surface that is of the first heat dissipation part and that is close to the substrate 210 is connected to the surface that is of the second structural member 250 and that is away from the substrate 210. The first heat sink 270 includes the protrusion part protruding toward the substrate 210, and the protrusion part is accommodated in the first avoidance space. The protrusion part may be connected to the first structural member 240, that is, a surface that is of the protrusion part and that is close to the substrate 210 is connected to the surface that is of the first structural member 240 and that is away from the substrate 210. There is an air gap between the first heat sink 270 and the second heat sink 280. It can be further seen from FIG. 11 and FIG. 12 that the region of the orthographic projection of the first heat sink 270 on the surface of the substrate 210 partially overlaps a region of orthographic projection of the first heat dissipation part of the second heat sink 280 on the surface of the substrate 210. The region of the orthographic projection of the first heat sink 270 on the surface of the substrate 210 does not overlap a region of orthographic projection of the second heat dissipation part of the second heat sink 280 on the surface of the substrate 210.

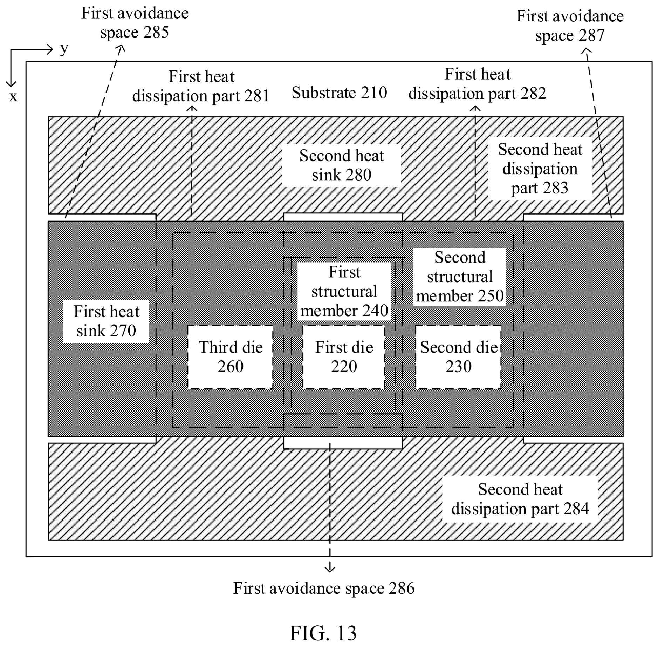

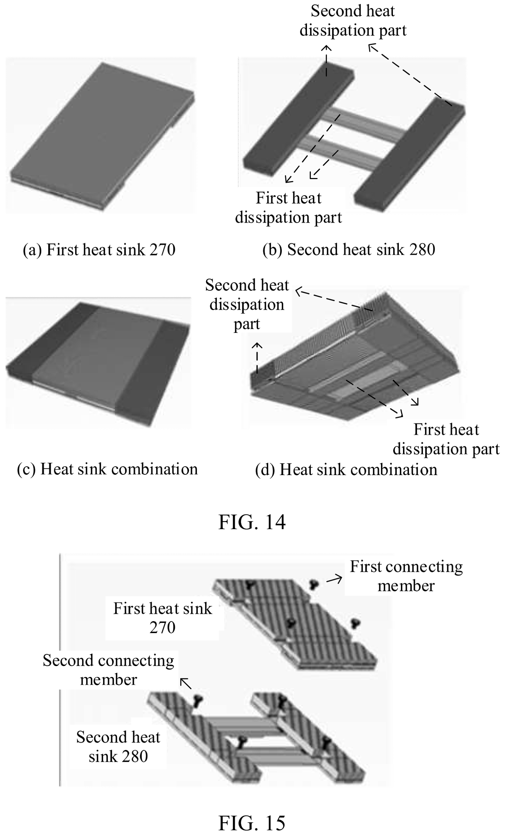

When the second heat sink may form the first avoidance space, the second heat sink may include at least one first heat dissipation part and at least one second heat dissipation part, so that the second heat sink may form at least one first avoidance space. FIG. 11 and FIG. 12 show that the second heat sink includes one first heat dissipation part, one second heat dissipation part, and one first avoidance space. FIG. 13 and FIG. 14 show that the second heat sink includes a plurality of first heat dissipation parts, a plurality of second heat dissipation parts, and a plurality of first avoidance spaces.

FIG. 13 is a top view of a package according to an embodiment of this application. In FIG. 13, the substrate 210, the first die 220, the second die 230, the first structural member 240, the second structural member 250, the third die 260, the first heat sink 270, and the second heat sink 280 are included. The second heat sink 280 includes a first heat dissipation part 281, a first heat dissipation part 282, a second heat dissipation part 283, and a second heat dissipation part 284, so that the second heat sink 280 can form a first avoidance space 285, a first avoidance space 286, and a first avoidance space 287. The first heat dissipation part 281 and the first heat dissipation part 282 are disposed side by side, the second heat dissipation part 283 and the second heat dissipation part 284 are disposed side by side, and two opposite sides of each first heat dissipation part each are connected to one second heat dissipation part. The first avoidance space 285, the first avoidance space 286, and the first avoidance space 287 are located between the second heat dissipation part 283 and the second heat dissipation part 284. In addition, the first avoidance space 285 is located on a side that is of the first heat dissipation part 281 and that is away from the first heat dissipation part 282, the first avoidance space 286 is located between the first heat dissipation part 281 and the first heat dissipation part 282, and the first avoidance space 287 is located on a side that is of the first heat dissipation part 282 and that is away from the first heat dissipation part 281. The first heat sink 270 may include one protrusion part protruding toward the substrate 210, the protrusion part is accommodated in the first avoidance space 286, and the protrusion part is connected to the first structural member 240. Alternatively, the first heat sink may include three protrusion parts protruding toward the substrate 210. The three protrusion parts are respectively accommodated in the first avoidance space 285, the first avoidance space 286, and the first avoidance space 287, and the protrusion part accommodated in the first avoidance space 286 is connected to the first structural member 240. It can be further seen from FIG. 13 that the region of the orthographic projection of the first heat sink 270 on the surface of the substrate 210 partially overlaps regions of orthographic projection of the first heat dissipation part 281 and the first heat dissipation part 282 on the surface of the substrate 210. The region of the orthographic projection of the first heat sink 270 on the surface of the substrate 210 does not overlap regions of orthographic projection of the second heat dissipation part 283 and the second heat dissipation part 284 on the surface of the substrate 210.

For example, FIG. 14 is a three-dimensional diagram of the first heat sink 270 and the second heat sink 280. FIG. 14 is a diagram of structures of heat sinks according to an embodiment of this application. (a) in FIG. 14 is a diagram of a structure of the first heat sink 270. The first heat sink 270 includes three protrusion parts protruding toward the substrate 210. (b) in FIG. 14 is a diagram of a structure of the second heat sink 280. The second heat sink 280 includes two first heat dissipation parts and two second heat dissipation parts, to form three first avoidance spaces. (c) in FIG. 14 is a diagram of an upper surface of a structure (namely, a heat sink combination) obtained by combining the first heat sink 270 and the second heat sink 280. There is an air gap between the first heat sink 270 and the second heat sink 280. The upper surface of the heat sink combination is a surface away from the substrate 210. (d) in FIG. 14 is a diagram of a lower surface of the heat sink combination. The lower surface of the heat sink combination is a surface close to the substrate 210. A structure of the first heat sink 270 in FIG. 14 is similar to that of the first heat sink 270 in FIG. 13, and a structure of the second heat sink 280 in FIG. 14 is similar to that of the second heat sink 280 in FIG. 13. Details are not described herein again.

Optionally, the first heat sink 270 may be connected to the second structural member 250 via a first connecting member, to be fastened to the side that is of the second structural member 250 and that is away from the substrate 210. Alternatively, the first heat sink 270 may be connected to the second heat sink 280 via the first connecting member, to be fastened to the side that is of the second heat sink 280 and that is away from the substrate 210. Alternatively, the first heat sink 270 may be connected to the substrate 210 via the first connecting member, to be fastened to the substrate 210.

Optionally, the second heat sink 280 may be connected to the substrate 210 via a second connecting member, to be fastened to the substrate 210.

Specific types of the first connecting member and the second connecting member are not limited in embodiments of this application. For example, the first connecting member and/or the second connecting member may be a screw, a screw with a spring, or the like. The first connecting member and the second connecting member may be the same material or different. This is not limited in embodiments of this application.

When the first connecting member and the second connecting member are screws with springs, a bottom of the screw may be a spring. The screw may be a screw made of a material with low thermal conductivity, and the material with low thermal conductivity may be hard plastic. Because the screw with the spring has poor thermal conductivity, heat exchange between two structures (for example, the first heat sink and the second structural member or the first heat sink and the second heat sink) via the screw with the spring can be reduced, to implement heat insulation.

FIG. 15 is a diagram of structures of heat sinks and connecting members according to an embodiment of this application. In FIG. 15, the first heat sink 270 may be fastened to the second structural member 250, the second heat sink 280, or the substrate 210 via four first connecting members. In FIG. 15, the second heat sink 280 may be fastened to the substrate 210 via four second connecting members.

In some embodiments, an upper surface of the first heat sink 270 and/or an upper surface of the second heat sink 280 may be planar or non-planar. The upper surface of the first heat sink 270 is a surface that is of the first heat sink 270 and that is away from the substrate 210. The upper surface of the second heat sink 280 is a surface that is of the second heat sink 280 and that is away from the substrate 210.

When the upper surfaces of the first heat sink 270 and the second heat sink 280 are planar, a height from the upper surface of the first heat sink 270 to an upper surface of the substrate 210 may be the same as or different from a height from the upper surface of the second heat sink 280 to the upper surface of the substrate 210. This is not limited in embodiments of this application.

Optionally, when power consumption of the first die 220 is less than a fourth preset threshold, the first structural member 240 may be a heat sink. When the first structural member 240 is a heat sink, the package may not include the first heat sink 270. Similarly, when power consumption of the second die 230 is less than a fifth preset threshold, the second structural member 250 may be a heat sink. When the second structural member 250 is a heat sink, the package may not include the second heat sink 280. Specific values of the fourth preset threshold and the fifth preset threshold are not limited in embodiments of this application, and may be set based on an actual requirement. The fourth preset threshold and the fifth preset threshold may be the same or different.

Temperature data shown in Table 1 can be obtained by measuring temperatures of the package in embodiments of this application and a package that shares a heat dissipation resource.

**Table 1 Temperature data table**

| Package | First die | Second die |
|---|---|---|
| Package 1 | 88.19 | 94.85 |
| Package 2 | 95.11 | 89.79 |

In Table 1, the package 1 is a package in which a plurality of dies share a same heat dissipation resource, and the package 2 is the package in embodiments of this application. A specification of a maximum temperature at which the first die operates for a long time is 105 degrees Celsius (°C), and a specification of a maximum temperature at which the second die operates for a long time is 95°C. If a temperature of the die exceeds the specification of the maximum temperature at which the die operates for a long time, the die is likely to be damaged. As shown in Table 1, in the package 1, a temperature margin of the first die is 105 - 88.19 = 16.81°C, and a temperature margin of the second die is 95 - 94.85 = 0.15°C. In the package in embodiments of this application, a temperature margin of the first die is 105 - 95.11 = 9.89°C, and a temperature margin of the second die is 95 - 89.79 = 5.21°C. In other words, in the package 1, although the first die has a large temperature margin, the second die has a small temperature margin, and consequently, the second die has a large potential over-temperature risk and is likely to be damaged. However, the first die and the second die in embodiments of this application each have a large temperature margin, so that the first die and the second die have a low potential over-temperature risk, and are not likely to be damaged. In other words, the package in embodiments of this application can reduce impact of thermal crosstalk between the dies and improve heat dissipation effect.

An embodiment of this application may further provide a method for preparing a package. The method includes: forming a substrate 210, a first die 220, a second die 230, a first structural member 240, and a second structural member 250; and combining the substrate 210, the first die 220, the second die 230, the first structural member 240, and the second structural member 250, to form the package shown in FIG. 2 to FIG. 7. Alternatively, the method includes: forming the substrate 210; forming the first die 220 and the second die 230 on the substrate 210; and forming the first structural member 240 and the second structural member 250 on sides that are of the first die 220 and the second die 230 and that are away from the substrate 210.

In some embodiments, the method further includes: forming a first heat sink 270 and/or a second heat sink 280; and combining the first heat sink 270 and/or the second heat sink 280 and the package shown in FIG. 2 to FIG. 7, to form the package shown in FIG. 8 to FIG. 13. Alternatively, the method further includes: forming the first heat sink 270 on a side that is of the first structural member 240 and that is away from the substrate 210; and/or forming the second heat sink 280 on a side that is of the second structural member 250 and that is away from the substrate 210.

An embodiment of this application may further provide a chip. The chip includes the package shown in FIG. 2 to FIG. 13.

An embodiment of this application may further provide an electronic apparatus. The electronic apparatus includes the package shown in FIG. 2 to FIG. 13. Alternatively, the electronic apparatus includes the foregoing chip.

The foregoing descriptions are merely specific implementations of this application, but the protection scope of this application is not limited thereto. Any variation or replacement that can be readily figured out by a person skilled in the art within the technical scope disclosed in this application shall fall within the protection scope of this application. Therefore, the protection scope of this application shall be subject to the protection scope of the claims.

## Claims

1. A package, comprising a substrate, and a first die, a second die, a first structural member, and a second structural member that are disposed on the substrate, wherein a first dielectric material is disposed between the first die and the second die;
the first structural member is disposed on a side that is of the first die and that is away from the substrate, and the first die is located in a region of orthographic projection of the first structural member on a surface of the substrate; and
the second structural member is disposed on a side that is of the second die and that is away from the substrate, the second die is located in a region of orthographic projection of the second structural member on the surface of the substrate, and there is an air gap between the first structural member and the second structural member.

2. The package according to claim 1, wherein an edge of the first structural member comprises a first bending part bent toward the substrate, and the first bending part is connected to the substrate; and/or
an edge of the second structural member comprises a second bending part bent toward the substrate, and the second bending part is connected to the substrate.

3. The package according to claim 2, wherein the first bending part and/or the second bending part are/is of a stepped shape.

4. The package according to any one of claims 1 to 3, wherein the first structural member comprises a first protrusion structure protruding toward the substrate, and the first protrusion structure is connected to the substrate; and/or
the second structural member comprises a second protrusion structure protruding toward the substrate, and the second protrusion structure is connected to the substrate.

5. The package according to any one of claims 1 to 4, wherein the second structural member is provided with an opening, and the first structural member is located in the opening of the second structural member.

6. The package according to any one of claims 1 to 5, wherein the package further comprises a third die, the third die is disposed on the substrate, and the third die is located in the region of the orthographic projection of the first structural member or the second structural member on the surface of the substrate.

7. The package according to any one of claims 1 to 6, wherein the package further comprises a first heat sink, the first heat sink is disposed on a side that is of the first structural member and that is away from the substrate, and a surface that is of the first heat sink and that is close to the substrate is connected to a surface that is of the first structural member and that is away from the substrate.

8. The package according to claim 7, wherein the first heat sink is not in contact with the second structural member.

9. The package according to claim 7 or 8, wherein the package further comprises a second heat sink, the second heat sink is disposed on a side that is of the second structural member and that is away from the substrate, and a surface that is of the second heat sink and that is close to the substrate is connected to a surface that is of the second structural member and that is away from the substrate.

10. The package according to claim 9, wherein the second heat sink is not in contact with the first structural member.

11. The package according to claim 9 or 10, wherein there is an air gap between the first heat sink and the second heat sink.

12. The package according to any one of claims 9 to 11, wherein the second heat sink comprises a first heat dissipation part and a second heat dissipation part, a surface that is of the first heat dissipation part and that is close to the substrate is connected to the surface that is of the second structural member and that is away from the substrate, and the second heat dissipation part and the first heat dissipation part are disposed at an included angle on a plane parallel to the substrate.

13. The package according to any one of claims 9 to 12, wherein the second heat sink forms a first avoidance space, and the first heat sink is located in the first avoidance space.

14. The package according to claim 13, wherein the first heat sink comprises a protrusion part protruding toward the substrate, and the protrusion part is accommodated in the first avoidance space.

15. The package according to claim 14, wherein a surface that is of the protrusion part and that is close to the substrate is connected to the surface that is of the first structural member and that is away from the substrate.

16. A chip, comprising the package according to any one of claims 1 to 15.

17. An electronic apparatus, comprising the package according to any one of claims 1 to 15 or the chip according to claim 16.
